(19) Europäisches Patentamt
European Patent Office
Office européen des brevets

(11) **EP 3 361 471 A1**

(12) **EUROPEAN PATENT APPLICATION**
published in accordance with Art. 153(4) EPC

(43) Date of publication:
**15.08.2018 Bulletin 2018/33**

(21) Application number: **16853349.5**

(22) Date of filing: **01.09.2016**

(51) Int Cl.:
**G09G 3/32** (2016.01)          **G09G 3/20** (2006.01)
**H01L 33/00** (2010.01)          **H05B 37/02** (2006.01)

(86) International application number:
**PCT/JP2016/075685**

(87) International publication number:
**WO 2017/061195 (13.04.2017 Gazette 2017/15)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **05.10.2015 JP 2015197515**

(71) Applicant: **Mitsubishi Electric Corporation
Chiyoda-ku
Tokyo 100-8310 (JP)**

(72) Inventors:
• **MACHIDA, Naoyuki**
  **Tokyo 100-8310 (JP)**
• **SHIBUE, Shigenori**
  **Tokyo 100-8310 (JP)**
• **ASAMURA, Yoshinori**
  **Tokyo 100-8310 (JP)**

(74) Representative: **Pfenning, Meinig & Partner mbB
Patent- und Rechtsanwälte
An der Frauenkirche 20
01067 Dresden (DE)**

(54) **LIGHT-EMITTING DIODE DISPLAY DEVICE**

(57) A light-emitting diode display device includes: a display that includes a light-emitting diode; a drive unit that drives the light-emitting diode; a lighting time storage unit that stores a cumulative lighting time of the light-emitting diode; a first temperature detection unit that detects a first temperature of the light-emitting diode; a first temperature storage unit that stores the first temperature; an aging display that includes a measurement light-emitting diode; a drive unit that drives the measurement light-emitting diode; a drive data generation unit that generates drive data; a second temperature detection unit that detects a temperature of the measurement light-emitting diode; a second temperature storage unit that stores a second temperature; a brightness measurement unit that measures brightness of the measurement light-emitting diode; a brightness reduction rate storage unit that stores a brightness reduction rate; a compensation factor calculation unit that finds a compensation factor from the cumulative lighting time and the brightness reduction rate, and corrects the compensation factor on the basis of a difference between the first temperature and the second temperature; and a brightness compensation circuit that compensates the brightness of the light-emitting diode on the basis of the compensation factor.

FIG.1

**Description**

Field

The present invention relates to a light-emitting diode display device which includes a plurality of light-emitting diodes arranged in a matrix and displays image information by performing flashing control on the light-emitting diodes individually.

Background

Light-emitting diode display devices using light-emitting diodes are widely used in applications such as outdoor and indoor advertisement display due to technological development and cost reduction of the light-emitting diodes. Hereinafter, the light-emitting diode will be abbreviated as LED in some cases.

These light-emitting diode display devices have mainly displayed natural images and animated videos, but with a reduction in the pixel pitch allowing a reduction in the visible distance, the light-emitting diode display devices are also used indoors for displaying images in a conference room or images on a personal computer for a monitoring purpose. Particularly in the monitoring application, the light-emitting diode display devices often display images close to still images on a personal computer. However, the brightness of the light-emitting diodes is reduced as the lighting time thereof gets longer, whereby the light-emitting diodes have different brightness reduction rates depending on the images and thus result in having a variation in brightness and color for each pixel.

In order to reduce such variation in brightness or color, there is proposed a method of compensating brightness data by detecting brightness of a display of the light-emitting diode, or a method of integrating display time of the light-emitting diode and compensating brightness in accordance with the integrated time (refer to Patent Literatures 1 and 2, for example).

Citation List

Patent Literature

Patent Literature 1: Japanese Patent Application Laid-open No. H11-15437
Patent Literature 2: Japanese Patent Application Laid-open No. 2006-330158

Summary

Technical Problem

Regarding the variation in brightness and color caused by the difference in the lighting time of the light-emitting diodes, the brightness reduction rates of the light-emitting diodes can be predicted to some extent by a life test or the like. However, it has been difficult to predict a difference in the characteristics caused by a difference in the production lot of the light-emitting diodes.

Although the accuracy of compensating the brightness can be improved by detecting the actual brightness of an LED display, such detection requires display of an image for measuring the brightness, which causes the need to stop the operation of a system running 24 hours. As a result, the variation in the brightness or color remains with no improvement in the accuracy of compensation, thereby degrading image quality of the LED display and causing the need to replace the display with a new LED module in order to solve the degradation in the image quality.

It is an object of the present invention to provide a light-emitting diode display device including a brightness control function that compensates a variation in brightness caused by aging of the brightness characteristic of individual light-emitting diode elements.

Solution to Problem

In order to solve the aforementioned problem and achieve the object, the present invention includes: a display that includes a plurality of light-emitting diodes; a first drive unit that drives the light-emitting diodes on the basis of an image signal; a lighting time storage unit that stores a cumulative lighting time being an accumulated lighting time of the light-emitting diodes; a first temperature detection unit that detects a first temperature being a temperature of each of the light-emitting diodes; a first temperature storage unit that stores the first temperature; an aging display that includes a measurement light-emitting diode; a second drive unit that drives the measurement light-emitting diode on the basis of drive data; a drive data generation unit that generates the drive data; a second temperature detection unit that detects a temperature of the measurement light-emitting diode; and a second temperature storage unit that stores a second temperature being a value based on the temperature detected by the second temperature detection unit. The present invention further includes: a brightness measurement unit that measures brightness of the measurement light-emitting diode; a brightness reduction rate storage unit that stores the brightness measured by the brightness measurement unit as a brightness reduction rate in association with a lighting time of the measurement light-emitting diode; a compensation factor calculation unit that finds a compensation factor for the light-emitting diodes on the basis of the cumulative lighting time and the brightness reduction rate, and correct the compensation factor on the basis of a difference between the first temperature and the second temperature; and a brightness compensation circuit that compensates the brightness of the light-emitting diodes in the image signal on the basis of the compensation factor.

Advantageous Effects of Invention

According to the present invention, there can be provided the light-emitting diode display device including the brightness control function that compensates the variation in brightness caused by aging of the brightness characteristic of the individual light-emitting diode elements.

Brief Description of Drawings

FIG. 1 is an overall system diagram of a light-emitting diode display device according to a first embodiment of the present invention.
FIG. 2 is an internal block diagram of an LED display unit included in the light-emitting diode display device according to the first embodiment.
FIG. 3 is an internal block diagram of an LED aging unit included in the light-emitting diode display device according to the first embodiment.
FIG. 4 is a graph illustrating the relationship between lighting time and a brightness reduction rate of a green light-emitting diode included in an LED on each of an LED display and an LED aging display according to the first embodiment.
FIG. 5 is a graph illustrating the relationship between the lighting time and the brightness reduction rate obtained on the basis of measurement of the brightness of a light-emitting diode of each color in the LED included in the LED aging display, according to the first embodiment.
FIG. 6 is a graph illustrating a change in a difference in the brightness reduction rate as a function of the lighting time, the difference being caused by a difference in temperature of the light-emitting diodes driven in the first embodiment.
FIG. 7 is a flowchart illustrating a method of compensating brightness of the light-emitting diode display device according to the first embodiment.
FIG. 8 is a diagram illustrating an example of PWM drive of the light-emitting diode in the first embodiment.
FIG. 9 is a graph illustrating the method of compensating the brightness of the light-emitting diode display device according to the first embodiment.
FIG. 10 is a graph illustrating a method of compensating brightness of a light-emitting diode display device according to a second embodiment of the present invention.
FIG. 11 is a flowchart illustrating the method of compensating the brightness of the light-emitting diode display device according to the second embodiment.
FIG. 12 is a graph for explaining the relationship between the lighting time and the brightness reduction rate of an LED aging display at a plurality of duty ratios according to a third embodiment of the present invention.

Description of Embodiments

A light-emitting diode display device according to an embodiment of the present invention will now be described in detail with reference to the drawings. Note that the present invention is not to be limited to the embodiment.

First Embodiment.

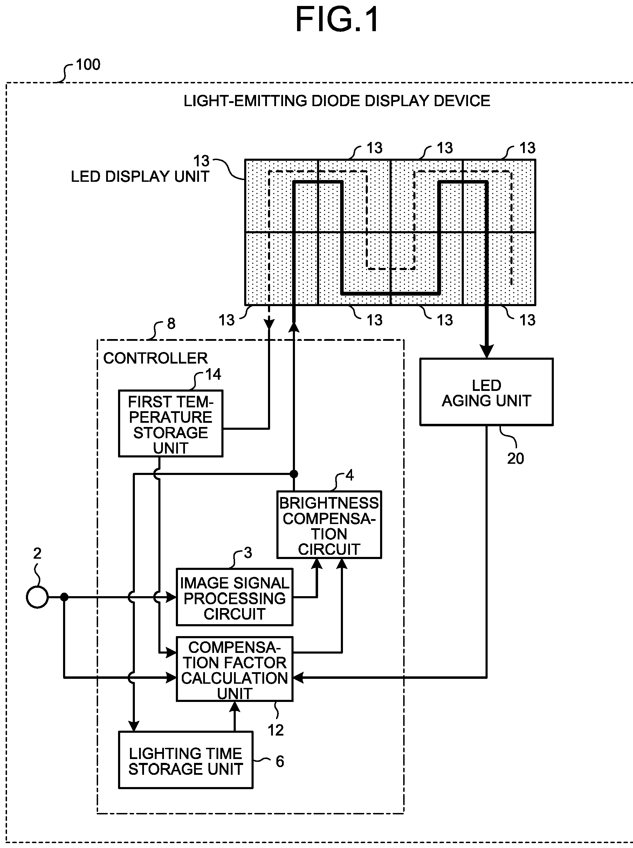

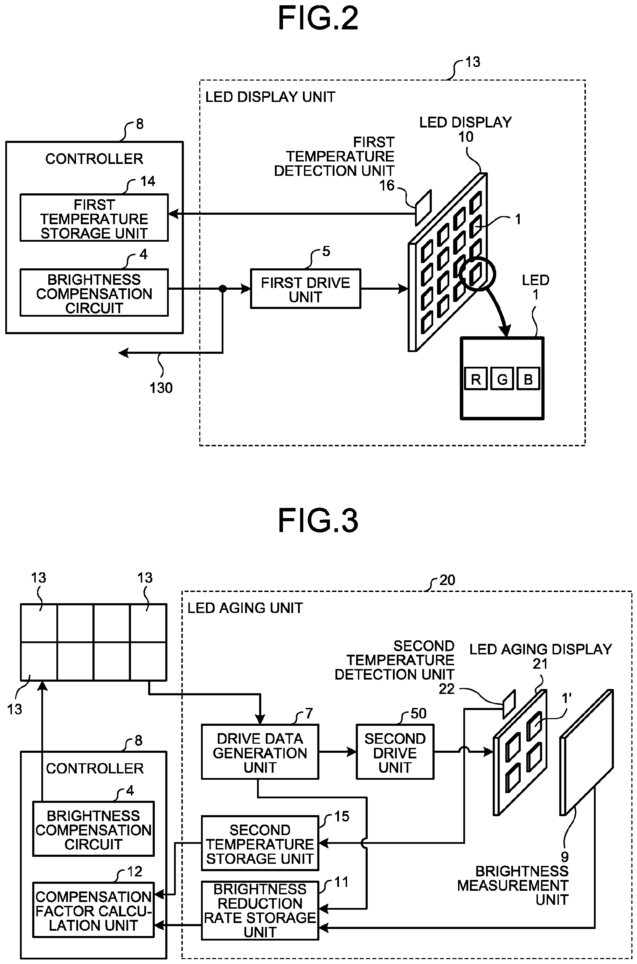

FIG. 1 is an overall system diagram of a light-emitting diode display device 100 according to a first embodiment of the present invention. FIG. 2 is an internal block diagram of an LED display unit 13 included in the light-emitting diode display device 100 according to the first embodiment. FIG. 3 is an internal block diagram of an LED aging unit 20 included in the light-emitting diode display device 100 according to the first embodiment.

The light-emitting diode display device 100 according to the first embodiment includes a plurality of the LED display units 13 making up a large screen, an input terminal 2 for an image signal, a controller 8 controlling the LED display units 13, and the LED aging unit 20 obtaining information on brightness degradation of a light-emitting diode. FIG. 1 illustrates an example of a total of eight of the LED display units 13, two arranged vertically and four arranged horizontally, to make up the large screen.

The controller 8 includes an image signal processing circuit 3 performing image signal processing on an image signal input from the input terminal 2, a brightness compensation circuit 4 compensating the brightness of the image signal which is an output signal of the image signal processing circuit 3, a lighting time storage unit 6 storing cumulative lighting time which is the lighting time accumulated for each of red (R), green (G), and blue (B) light-emitting diodes included in the LED display unit 13, a first temperature storage unit 14 storing temperature of the light-emitting diode of an LED display 10 in the LED display unit 13, and a compensation factor calculation unit 12 calculating a compensation factor.

The image signal processing circuit 3 performs scaling processing and the image signal processing such as gamma correction on the image signal input from the input terminal 2 in order for the signal to be displayed on the LED display 10 of the LED display unit 13, and outputs the signal to the brightness compensation circuit 4. The coloring property varies depending on the display device displaying an image. A gamma value is a numerical expression of such property, and the gamma correction corrects an image in advance by using the gamma value such that the brightness of an original image does not change. The brightness compensation circuit 4 measures a brightness value of the image signal input via the image signal processing circuit 3, calculates the cumulative lighting time for each color in each LED display 10, and stores the cumulative lighting time in the lighting time storage unit 6.

The image signal output from the brightness compensation circuit 4 is input to the LED display unit 13 and the LED aging unit 20.

As illustrated in FIG. 2, the LED display unit 13 includes the LED display 10 which is a display made up of a plurality of LEDs 1, a first drive unit 5 driving the light-emitting diode of the LED display 10 on the basis of the image signal output from the brightness compensation circuit 4, and a first temperature detection unit 16 detecting a first temperature which is the temperature of the light-emitting diode included in the LED 1 on the LED display 10. Specifically, the output of the brightness compensation circuit 4 is input to the first drive unit 5 of the first LED display unit 13 and at the same time output to the plurality of LED display units 13 and LED aging 20 that are subsequently connected in a daisy chain via a signal line 130. The first temperature detection unit 16 detects the temperature of each light-emitting diode of the LED 1 by electrical means, and may thus be provided to be able to detect the temperature of the light-emitting diode of each color in all the LEDs 1. The temperature of the light-emitting diode in the LED 1 detected by the first temperature detection unit 16 is stored in the first temperature storage unit 14.

The first drive unit 5 of the LED display unit 13 selects an area required for display on the basis of the image signal input from the brightness compensation circuit 4, thereby driving the LED display 10 including the plurality of LEDs 1. Each LED 1 is a set of light-emitting diodes including three light-emitting diodes of red (R), green (G), and blue (B) colors. The LED display 10 illustrated in FIG. 2 includes $4 \times 4 = 16$ sets of the LEDs 1.

As illustrated in FIG. 3, the LED aging unit 20 includes: an LED aging display 21 which is an aging display including an LED 1' with a measurement light-emitting diode that has the same characteristic as the LED 1 included in the LED display 10; a second drive unit 50 driving the measurement light-emitting diode of the LED aging display 21 on the basis of drive data; a drive data generation unit 7 generating drive data by which a display pattern on the LED aging display 21 is realized; a brightness measurement unit 9 measuring the brightness of the measurement light-emitting diode of the LED aging display 21; a brightness reduction rate storage unit 11 storing the brightness measured by the brightness measurement unit 9 as a brightness reduction rate in association with the lighting time of the measurement light-emitting diode; a second temperature detection unit 22 detecting the temperature of the measurement light-emitting diode of each color included in the LED 1' of the LED aging display 21; and a second temperature storage unit 15 storing a second temperature based on the temperature of the measurement light-emitting diode detected by the second temperature detection unit 22. Specifically, the second temperature stored in the second temperature storage unit 15 is the temperature of the measurement light-emitting diode detected by the second temperature detection unit 22 or an average of the temperature for each color.

Here, the compensation factor calculation unit 12 included in the controller 8 calculates the compensation factor of the brightness on the basis of the brightness reduction rate stored in the brightness reduction rate storage unit 11 and the lighting time of each LED 1 stored in the lighting time storage unit 6. The compensation factor calculation unit 12 further compensates the compensation factor on the basis of a change in the brightness reduction rate dependent on a difference between the temperature of the light-emitting diode of the LED display 10 stored in the first temperature storage unit 14 and the temperature of the measurement light-emitting diode of the LED aging display 21 stored in the second temperature storage unit 15. The brightness compensation circuit 4 compensates the output of the image signal processing circuit 3 by image signal processing using the compensation factor that is calculated by the compensation factor calculation unit 12, and sends the corrected output to the LED display unit 13.

Data of the lighting time stored in the lighting time storage unit 6 is a cumulative value of the duration for which the light-emitting diode of each of red (R), green (G), and blue (B) colors is lit in each LED 1, where the value is accumulated every predetermined unit time. Specifically, when the light-emitting diode of a certain color is lit with the brightness at 10% duty ratio and the unit time of one hour, a cumulative lighting time obtained by accumulating 0.1 hour to the lighting time every hour is stored in the lighting time storage unit 6. The cumulative lighting time is thus a value normalized by the duty ratio. The operation performed in a method of controlling current by the duty ratio will be described later.

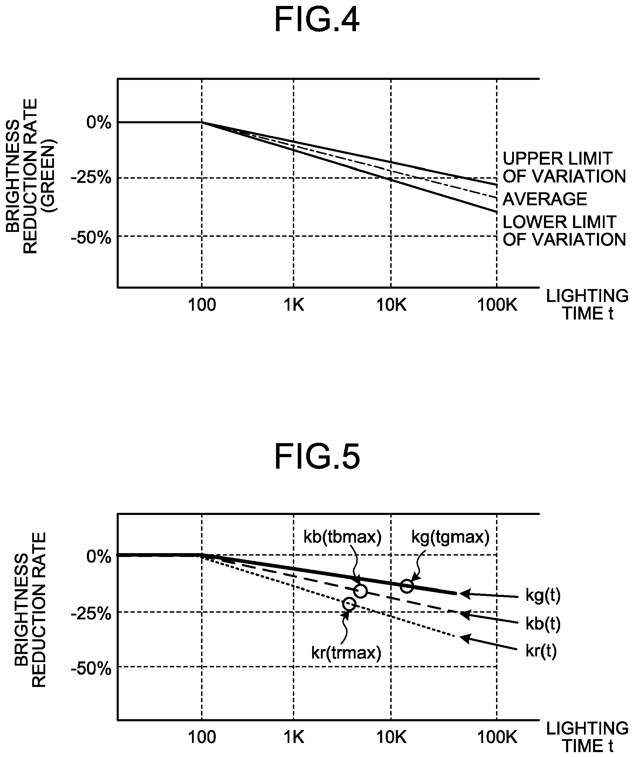

FIG. 4 is a graph illustrating the relationship between the lighting time and the brightness reduction rate of a green light-emitting diode of the LED 1 included in the LED display 10 and the LED 1' included in the LED aging display 21 according to the first embodiment. That is, FIG. 4 illustrates the relationship between the lighting time and the brightness of the green (G) light-emitting diode in the LED 1 and LED 1'. As illustrated in FIG. 4, the brightness of the light-emitting diode is reduced with the lighting time. However, a change in the brightness reduction rate over time varies as illustrated in FIG. 4, where an average lies between an upper limit of the variation and a lower limit of the variation.

The brightness reduction rate has conventionally been obtained by advance measurement. However, the light-emitting diode display device 100 according to the first embodiment is configured to measure the brightness reduction rate in real time by the LED aging unit 20. A method of measuring the brightness reduction rate will now be described.

The drive data generation unit 7 generates drive data that causes the LED aging display 21 to display a display pattern on the basis of an image signal output from the brightness compensation circuit 4, and the second drive unit 50 drives the LED aging display 21 on the basis of the drive data. The drive data generated by the drive data generation unit 7 is drive data in which a duty ratio at which the measurement light-emitting diode is driven is set to the maximum duty ratio among duty ratios at which the first drive unit 5 drives the light-emitting diode of the LED display 10. The duty ratio is a ratio of a period during which the light-emitting diode is lit in one frame period. The maximum duty ratio at which each LED display 10 performs display is obtained for each color, so that the light-emitting diode of each color on the LED aging display 21 is driven at the maximum duty ratio obtained for each color. When the maximum duty ratio of the light-emitting diode of a certain color on the LED display 10 is 100%, the display pattern of the light-emitting diode of such color on the LED aging display 21 may also be set to the duty ratio of 100%. The LED aging display 21 can thus secure, for each color, the lighting time equal to that of the light-emitting diode of the LED 1 having the longest lighting time among the plurality of LEDs 1 used in the LED display 10.

The LED aging display 21 includes a plurality of the LEDs 1' having the same light-emitting diodes as the LEDs 1. As with the LED 1, each LED 1' is a set of light-emitting diodes including three light-emitting diodes of red (R), green (G), and blue (B) colors. The LED aging display 21 illustrated in FIG. 3 includes 2 × 2 = 4 sets of the LEDs 1'. With the plurality of LEDs 1' included in the LED aging display 21, the brightness measurement unit 9 can find an average of the brightness of the light-emitting diode for each of red (R), green (G), and blue (B) colors in measuring the brightness. This allows acquisition of brightness data with a smaller variation in brightness as compared to a case where only one set of the LED 1' is provided. However, the LED aging display 21 may include one set of the LED 1'. Moreover, the light-emitting diodes need not be provided for three colors nor provided for all of the red (R), green (G), and blue (B) colors.

The brightness measurement unit 9 is disposed to face the LED aging display 21 and measures the brightness of the light-emitting diode of each color in each LED 1' on the LED aging display 21. Specifically, a photodiode capable of performing measurement with a wavelength in the visible range can be used as a measurement device included in the brightness measurement unit 9.

FIG. 5 is a graph illustrating the relationship between lighting time t and the brightness reduction rate obtained on the basis of measurement of the brightness of a light-emitting diode of each color in the LED 1' included in the LED aging display 21 according to the first embodiment. The brightness reduction rates of the red (R), green (G), and blue (B) light-emitting diodes in the LED 1' are indicated by $kr(t)$, $kg(t)$, and $kb(t)$, respectively, in FIG. 5 as functions of the lighting time t. The lighting time t is a value normalized by the duty ratio as described above, and the brightness reduction rate is a rate of reduction of current brightness with respect to initial brightness. When the plurality of LEDs 1' is disposed, the brightness for each color is an average of the brightness for each color.

The measured result of the brightness of the LED aging display 21 obtained by the brightness measurement unit 9 and the lighting time of the light-emitting diode of each color included in the LED aging display 21 obtained by the drive data generation unit 7 are stored in the brightness reduction rate storage unit 11, so that the brightness reduction rate of the light-emitting diode of each color with respect to the lighting time can be measured in real time.

Moreover, the brightness reduction rate with respect to the lighting time of the light-emitting diode is usually affected by the temperature at the time of driving thereof, and thus the brightness can be compensated more accurately by performing compensation based on a difference in temperature between the LED 1 included in the LED display 10 and the LED 1' included in the LED aging display 21.

When temperatures of the red (R), green (G), and blue (B) light-emitting diodes in each LED 1 making up the LED display 10 are first temperatures tr, tg, and tb, and temperatures of the red (R), green (G), and blue (B) light-emitting diodes in the LED 1' making up the LED aging display 21 are second temperatures tre, tge, and tbe, then temperature differences Tr, Tg, and Tb for the red (R), green (G), and blue (B) light-emitting diodes are expressed by the following expressions, respectively.

$$Tr = tr - tre$$

$$Tg = tg - tge$$

$$Tb = tb - tbe$$

Here, tr, tg, and tb are detected by the first temperature detection unit 16 and are the temperature values of the light-emitting diodes of the corresponding colors included in each LED 1. The values tre, tge, and tbe are detected by the second temperature detection unit 22 and represent the temperatures of the light-emitting diodes of the corresponding colors included in the LED 1', and are averages taken for the corresponding colors when the plurality of LEDs 1' is disposed. Let $r\beta$, $g\beta$, and $b\beta$ be thresholds of the temperature differences Tr, Tg, and Tb for the red (R), green (G), and blue (B) colors, respectively.

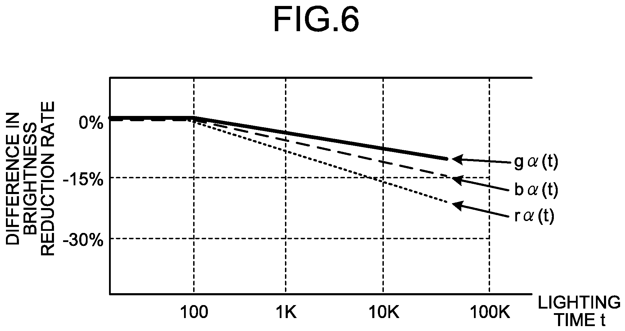

FIG. 6 is a graph illustrating a change in the difference in the brightness reduction rate as a function of the lighting time, the difference being caused by the difference in temperature of the light-emitting diodes driven in the first embodiment. The difference in the brightness reduction rate with respect to the temperature difference between each LED 1 making up the LED display 10 and the LED 1' making up the LED aging display 21 is expressed by temperature compensation factors $r\alpha$ (t), $g\alpha$ (t), and $b\alpha$ (t), which are functions of the lighting time t, for the red (R), green (G), and blue (B) colors, respectively. Information on the temperature compensation factors $r\alpha$ (t), $g\alpha$ (t), and $b\alpha$ (t) is held in advance in the compensation factor calculation unit 12 as a unique table.

The brightness reduction rate is affected by the temperature differences when the temperature differences Tr, Tg, and Tb satisfy $Tr \geq r\beta$, $Tg \geq g\beta$, and $Tb \geq b\beta$, or the effect of the temperature differences on the brightness reduction rate can be ignored when $Tr < r\beta$, $Tg < g\beta$, and $Tb < b\beta$.

Accordingly, when the brightness reduction rate is affected by the temperature differences, the temperature compensation factors $r\alpha$ (t), $g\alpha$ (t), and $b\alpha$ (t) illustrated in FIG. 6 may be used to be able to more accurately correct the brightness degradation.

A specific case will be considered in which both the LED 1 and the LED 1' continue to be driven when the temperature difference Tg between the green light-emitting diode of the LED 1 and the green light-emitting diode of the LED aging display 21 satisfies $Tg \geq g\beta$. In this case, when the lighting time t of 100K hours elapses in FIG. 6, the brightness value of the green light-emitting diode of the LED 1 is determined to be reduced 15% more than the brightness value calculated from the green light-emitting diode included in the LED aging display 21. When $Tg < g\beta$, on the other hand, the brightness value of the green light-emitting diode of the LED 1 is determined to be equal to the brightness value calculated from the green light-emitting diode included in the LED aging display 21.

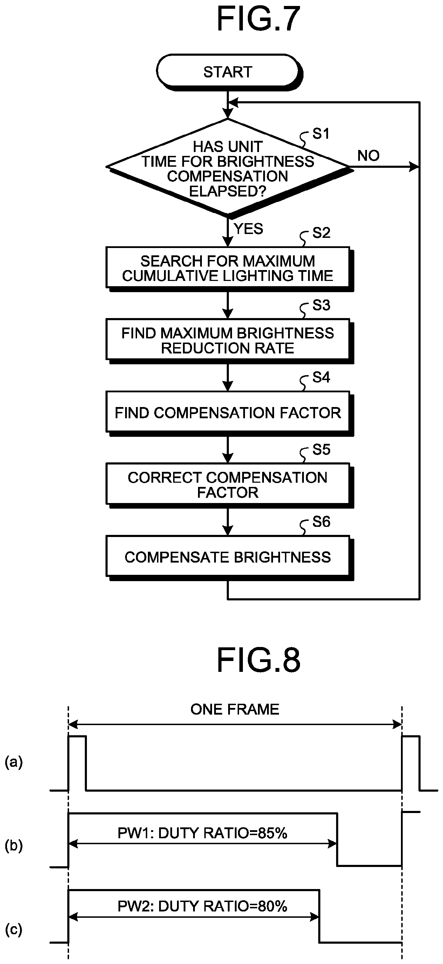

Now, the method of compensating the brightness according to the first embodiment will be described in detail. FIG. 7 is a flowchart illustrating the method of compensating the brightness of the light-emitting diode display device 100 according to the first embodiment.

In FIG. 7, the controller 8 determines whether or not a unit time for brightness compensation has elapsed on the basis of a timing unit (not illustrated) (step S1). Specifically, the unit time for the brightness compensation is 100 hours, for example. If the unit time for the brightness compensation has not elapsed (step S1: No), the process returns to step S1 again to make the determination. The process proceeds to step S2 if the unit time for the brightness compensation has elapsed (step S1: Yes).

In step S2, the compensation factor calculation unit 12 refers to the lighting time storage unit 6 to search for the maximum cumulative lighting time of the light-emitting diode of each color included in each LED 1 (step S2). Step S2 finds three values trmax, tgmax, and tbmax which represent the maximum cumulative lighting times of the red (R), green (G), and blue (B) light-emitting diodes, respectively, among the cumulative lighting times of the light-emitting diodes in all the LEDs 1.

Next, the compensation factor calculation unit 12 refers to the brightness reduction rate storage unit 11 included in the LED aging unit 20 to find the maximum brightness reduction rate krgb (tmax) by selecting the largest brightness reduction rate from among three brightness reduction rates corresponding to the maximum cumulative lighting times trmax, tgmax, and tbmax for red (R), green (G), and blue (B) colors found in step S2, respectively (step S3). Here, with tmax = (trmax, tgmax, tbmax), the maximum brightness reduction rate krgb (tmax) is expressed by the following expression (1) while using the functions kr (t), kg (t), and kb (t) of the brightness reduction rate illustrated in FIG. 5 earlier.
[Expression 1]

$$krgb(t \max) = MAX(kr(tr \max), kg(tg \max), kb(tb \max)) \qquad \cdots (1)$$

Next, the compensation factor calculation unit 12 refers to the lighting time storage unit 6 and the brightness reduction rate storage unit 11 to calculate, for the light-emitting diode of each color in all the LEDs 1 on the LED display 10, the compensation factor for the light-emitting diode of each color in each LED 1 on the basis of the cumulative lighting time, the brightness reduction rate with respect to the lighting time t, and the maximum brightness reduction rate krgb (tmax) found in step S3 (step S4). A specific example of the compensation factor will be described in detail later.

The compensation factor calculation unit 12 then finds the temperature differences Tr, Tg, and Tb with reference to the first temperature storage unit 14 storing the temperatures tr, tg, and tb of the light-emitting diodes included in the LED display 10 and the second temperature storage unit 15 storing the temperatures tre, tge, and tbe of the LED aging display 21. The temperature compensation factors illustrated in FIG. 6 are used depending on the presence or absence of the effect of the temperature differences Tr, Tg, and Tb on the brightness reduction rate, thereby correcting the compensation factor for the light-emitting diode of each color in each LED 1 included in the LED display 10 (step S5). A specific example of correcting the compensation factor will be described in detail later.

Finally, the brightness compensation circuit 4 uses the compensation factor for the light-emitting diode obtained through steps S4 and S5 to compensate the brightness of the light-emitting diode in the image signal supplied from the image signal processing circuit 3 (step S6). The process returns to step S1 after step S6.

Next, a specific example of the compensation factor found in step S4 will be described.

Let Rp, Gp, and Bp be the current brightness of the red (R), green (G), and blue (B) light-emitting diodes in the LED 1, respectively. Where t denotes the lighting time accumulated up to this point for each of the red (R), green (G), and blue (B) light-emitting diodes in the LED 1, the brightness reduction rates for the respective colors are expressed as kr (t), kg (t), and kb (t). Moreover, with the use of the maximum brightness reduction rate krgb (tmax) found in step S3, compensated brightness Rcomp, Gcomp, and Bcomp for the red (R), green (G), and blue (B) light-emitting diodes in the LED 1 are expressed by the following expression (2), respectively.
[Expression 2]

$$Rcomp = Rp * \frac{1}{(1 - kr(t))} * (1 - krgb(t \max))$$

$$Gcomp = Gp * \frac{1}{(1 - kg(t))} * (1 - krgb(t \max)) \qquad \cdots (2)$$

$$Bcomp = Bp * \frac{1}{(1 - kb(t))} * (1 - krgb(t \max))$$

Therefore, the compensation factor found in step S4 is a factor by which each of the current brightness Rp, Gp, and Bp is multiplied on the right side of the corresponding expression in expression (2). Here, the current brightness Rp, Gp, and Bp of the red (R), green (G), and blue (B) light-emitting diodes in the LED 1 in expression (2) are expressed by the following expression (3) with R0, G0, and B0 denoting the initial values of the brightness of the red (R), green (G), and blue (B) light-emitting diodes in the LED 1, respectively.
[Expression 3]

$$Rp = R0 * (1 - kr(t))$$

$$Gp = G0 * (1 - kg(t)) \qquad \cdots (3)$$

$$Bp = B0 * (1 - kb(t))$$

Substituting expression (3) into expression (2), the compensated brightness Rcomp, Gcomp, and Bcomp of the red (R), green (G), and blue (B) light-emitting diodes in the LED 1 are expressed by the following expression (4), respectively.

[Expression 4]

$$Rcomp = R0 * \left(1 - krgb(t\max)\right)$$
$$Gcomp = G0 * \left(1 - krgb(t\max)\right) \quad \cdots (4)$$
$$Bcomp = B0 * \left(1 - krgb(t\max)\right)$$

As expressed in expression (4), the compensated brightness is uniformly compensated by the maximum brightness reduction rate krgb (tmax) with respect to the initial values R0, G0, and B0 of the brightness of the red (R), green (G), and blue (B) light-emitting diodes in the LED 1. That is, the brightness is compensated such that the initial values R0, G0, and B0 of the brightness are reduced at the same maximum brightness reduction rate krgb (tmax), whereby the variation in the brightness can be reduced to be able to maintain uniformity of the brightness.

A specific example of correcting the compensation factor performed in step S5 will be further described.

The compensation factor calculation unit 12 refers to the first temperature storage unit 14 and the second temperature storage unit 15 to calculate the temperature differences Tr, Tg, and Tb between the temperatures tr, tg, and tb of the light-emitting diodes of corresponding colors in all the LEDs 1 of the LED display 10 and the temperatures tre, tge, and tbe obtained from the light-emitting diodes of corresponding colors in the LED 1' of the LED aging display 21.

When an error in the brightness reduction rate caused by the temperature difference is corrected with the temperature compensation factors rα (t), gα (t), and bα (t), the compensated brightness Rcomp, Gcomp, and Bcomp of the red (R), green (G), and blue (B) light-emitting diodes in the LED 1 compensated with the corrected compensation factors are expressed by the following expression (5), respectively.

[Expression 5]

$$Rcomp = R0 * \left(1 - krgb(t\max)\right) * \left(1 - r\alpha(t)\right)$$
$$Gcomp = G0 * \left(1 - krgb(t\max)\right) * \left(1 - g\alpha(t)\right) \quad \cdots (5)$$
$$Bcomp = B0 * \left(1 - krgb(t\max)\right) * \left(1 - b\alpha(t)\right)$$

Here, assuming that the brightness reduction rate is affected by the temperature differences when Tr ≥ rβ, Tg ≥ gβ, and Tb ≥ bβ are satisfied and that the effect of the temperature differences on the brightness reduction rate can be ignored when Tr < rβ, Tg < gβ, and Tb < bβ as described above, each brightness in the case of Tr < rβ, Tg < gβ, and Tb < bβ needs to be matched with the brightness in the case of Tr ≥ rβ, Tg ≥ gβ, and Tb ≥ bβ in which the brightness reduction rate is affected by the temperature differences.

Specifically, the compensation factor found in step S4 is corrected in step S5 in order for the brightness reduction rate of the light-emitting diodes in the LED 1, which have the temperature differences Tr, Tg, and Tb less than the corresponding thresholds rβ, gβ, and bβ and thus the brightness reduction rate not being affected by the temperature differences, to match the brightness of the light-emitting diodes in the LED 1 which have the temperature differences Tr, Tg, and Tb larger than or equal to the corresponding thresholds rβ, gβ, and bβ and thus the large brightness reduction rate.

That is, in step S5, the compensation factor is corrected as in expression (5) by using the temperature compensation factors rα (t), gα (t), and bα (t) when Tr < rβ, Tg < gβ, and Tb < bβ, or when Tr ≥ rβ, Tg ≥ gβ, and Tb ≥ bβ, correction of the brightness compensation by the temperature differences is not performed by setting rα (t) = 0, gα (t) = 0, and bα (t) = 0 in expression (5). Thus, correction of the compensation factor in step S5 is performed by multiplication or no multiplication by the factors (1 - rα (t)), (1 - gα (t)), and (1 - bα (t)). Note that the brightness reduction rate is not affected by the temperature differences when no light-emitting diode with Tr ≥ rβ, Tg ≥ gβ, and Tb ≥ bβ is included in the LED 1, in which case the compensation factor need not be corrected as in expression (5).

The brightness of the light-emitting diode in the LED 1 is adjusted by using a pulse width modulation scheme. The pulse width modulation is hereinafter referred to as PWM. FIG. 8 is a diagram illustrating an example of PWM drive of the light-emitting diode in the first embodiment. A fundamental period of the PWM is illustrated in (a) of FIG. 8 and is shorter than or equal to one frame period of an image signal. The duty ratio of the pulse width is 85% in a case illustrated in (b) of FIG. 8, and the light-emitting diode emits light for the duration of PW1. The duty ratio of the pulse width is 80% in a case illustrated in (c) of FIG. 8, and the light-emitting diode emits light for the duration of PW2. Such change in the duty ratio of the pulse width allows the brightness of the light-emitting diode in the LED 1 to be adjusted.

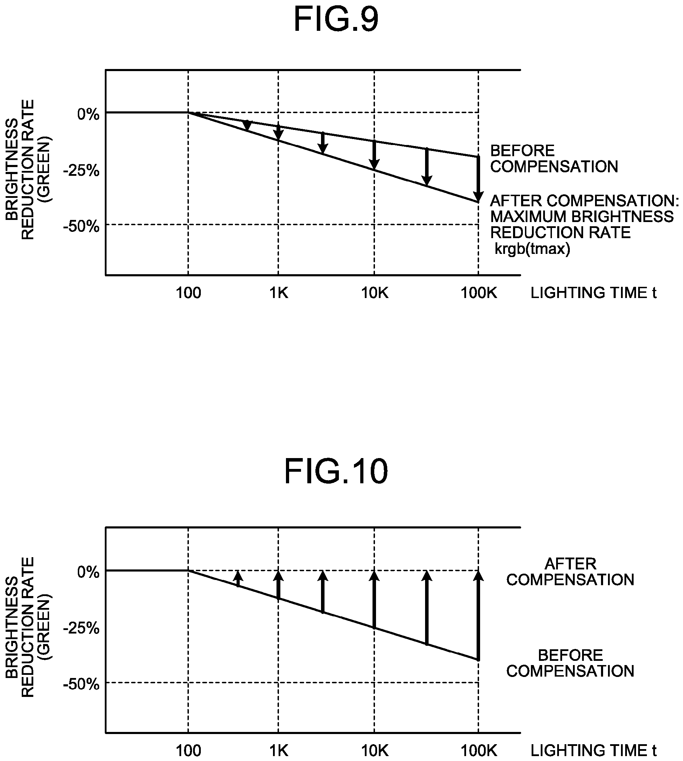

Therefore, also in step S6 described above, the brightness can be compensated by the brightness compensation circuit 4 changing the duty ratio of the pulse width so as to obtain the brightness after multiplication by the compensation factor. FIG. 9 is a graph illustrating the method of compensating the brightness of the light-emitting diode display device 100 according to the first embodiment. FIG. 9 illustrates an example of compensating the brightness of the green light-emitting diode included in the LED display 10.

As described above and illustrated in FIG. 9, the first embodiment compensates the brightness such that the light-emitting diode of each color in the LED 1 of the LED display 10 included in each LED display unit 13, namely all the light-emitting diodes included in the light-emitting diode display device 100, has the brightness reduction rate equal to the brightness reduction rate of the light-emitting diode having the maximum brightness reduction rate after compensation. That is, the brightness reduction rate is unified such that the brightness of all the light-emitting diodes after the compensation equals the maximum brightness reduction rate krgb (tmax).

As a result, the display can maintain uniformity of brightness and white balance as a whole to be able to improve the variation in brightness. In other words, the variation in brightness caused by aging of the brightness characteristics of the individual light-emitting diode elements can be compensated with high accuracy. The difficulty of viewing a display screen is resolved as a result. Moreover, the method of compensating the brightness employed by the light-emitting diode display device 100 of the first embodiment can gain an advantage that each light-emitting diode can have high initial brightness.

When a brightness sensor is used to attempt to measure the brightness of the LED display unit 13 continuously, the brightness sensor blocks the display of the LED display unit 13. However, according to the light-emitting diode display device 100 of the first embodiment, the LED aging unit 20 disposed outside the LED display unit 13 is used to measure the change in brightness, so that the change in brightness of the light-emitting diode of the LED display unit 13 over time can be continuously detected without the brightness sensor blocking the display of the LED display unit 13. As a result, the measurement of the brightness reduction rate and the compensation of the brightness can be implemented with high accuracy.

The brightness compensation circuit 4 measures the brightness value of the input image signal, namely the lighting time normalized by the duty ratio, to calculate the cumulative lighting time of all the light-emitting diodes of the LED display 10 included in each LED display unit 13, and at the same time compensates the brightness of all the light-emitting diodes included in the LED display unit 13 in advance on the basis of brightness degradation information obtained from the LED aging unit 20 to output the image signal.

This allows the compensation factor and the cumulative lighting time of the light-emitting diodes in each LED display 10 to be stored outside the LED display unit 13. Specifically, the compensation factor is stored in the compensation factor calculation unit 12, and the cumulative lighting time is stored in the lighting time storage unit 6. As a result, even when some of the LED display units 13 needs to be replaced due to a failure or the like, the cumulative lighting time for a replaced LED display unit 13 need only be calculated anew so that the brightness of the whole LED display unit 13 can be easily adjusted.

The light-emitting diode display device 100 according to the first embodiment is provided with the image signal processing circuit 3, the compensation factor calculation unit 12, the brightness compensation circuit 4, the lighting time storage unit 6, and the LED aging unit 20 outside the LED display unit 13 to be able to be easily applied to an LED display unit of an existing model. However, the controller 8 may be provided inside the LED display unit 13.

When the brightness measurement unit 9 is provided in the LED display unit 13 to measure the brightness reduction rate of the LED display 10 unlike the first embodiment, the brightness measurement unit 9 blocks an image displayed on the LED display 10. However, according to the light-emitting diode display device 100 of the first embodiment, the brightness measurement unit 9 measures the brightness of the LED aging display 21 disposed at a location different from the LED display 10, and thus need not block the image displayed on the LED display 10.


Second Embodiment.

In the first embodiment, the brightness is compensated such that all the light-emitting diodes in the LEDs 1 of each LED display 10 have the brightness reduction rate of the light-emitting diode with the largest reduction in brightness, or the maximum brightness reduction rate krgb (tmax). A second embodiment however employs another compensation method. The configuration of the overall system of the light-emitting diode display device 100 according to the second embodiment is illustrated in FIG. 1 as with the first embodiment.

FIG. 10 is a graph illustrating a method of compensating the brightness of the light-emitting diode display device 100 according to the second embodiment of the present invention. As illustrated in FIG. 10, when the initial value of the brightness is set smaller than the maximum brightness, specifically about 50% of the maximum brightness, constant brightness can be maintained by finding the brightness reduction rate of all the light-emitting diodes included in the LEDs 1 on the basis of information held in the lighting time storage unit 6 and the brightness reduction rate storage unit 11 and then compensating the brightness to be equal to the initial value.

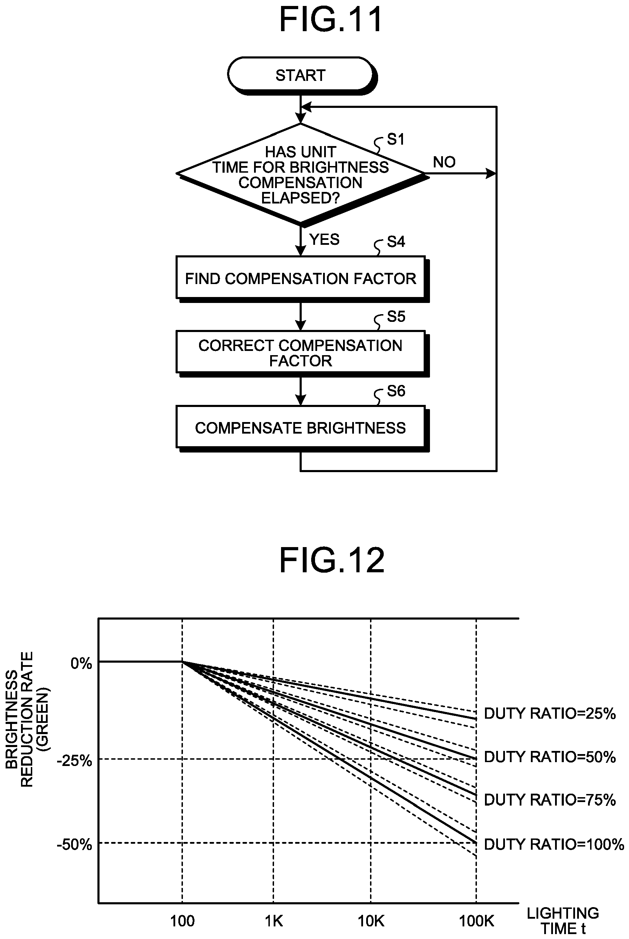

FIG. 11 is a flowchart illustrating the method of compensating the brightness of the light-emitting diode display device 100 according to the second embodiment. The flowchart illustrated in FIG. 11 is obtained by excluding steps S2 and S3 from the flowchart illustrated in FIG. 7. Moreover, the details of steps S4 and S5 are different from those in FIG.

7. Hereinafter, the differences between the flowcharts will mainly be described.

Let Rp, Gp, and Bp be the current brightness of the red (R), green (G), and blue (B) light-emitting diodes in the LED 1, respectively. With the use of the brightness reduction rates kr (t), kg (t), and kb (t) of the light-emitting diodes of the corresponding colors in the cumulative lighting time t illustrated in FIG. 5, the compensated brightness Rcomp, Gcomp, and Bcomp of the red (R), green (G), and blue (B) light-emitting diodes in the LED 1 are expressed by the following expression (6), respectively.

[Expression 6]

$$Rcomp = Rp * \frac{1}{(1 - kr(t))}$$

$$Gcomp = Gp * \frac{1}{(1 - kg(t))} \quad \cdots (6)$$

$$Bcomp = Bp * \frac{1}{(1 - kb(t))}$$

The compensation factor found in step S4 of FIG. 11 is a factor by which each of the current brightness Rp, Gp, and Bp is multiplied on the right side of the corresponding expression in expression (6). Substituting expression (3) into expression (6), the compensated brightness Rcomp, Gcomp, and Bcomp of the red (R), green (G), and blue (B) light-emitting diodes in the LED 1 are expressed by the following expression (7), respectively.

[Expression 7]

$$Rcomp = R0$$

$$Gcomp = G0 \quad \cdots (7)$$

$$Bcomp = B0$$

As expressed in expression (7), the brightness Rcomp, Gcomp, and Bcomp are compensated to the initial values of the brightness of the red (R), green (G), and blue (B) light-emitting diodes in the LED 1, respectively. That is, the compensation factor calculation unit 12 finds the compensation factor while the brightness compensation circuit 4 compensates the brightness in order for the brightness to be kept constant by maintaining the initial value of the brightness as illustrated in FIG. 10.

Note that correction of the compensation factor based on the effect of the temperature differences on the brightness reduction rate is expressed by the following expression (8) using the temperature compensation factors rα (t), gα (t), and bα (t) illustrated in FIG. 6.

[Expression 8]

$$Rcomp = R0 * \frac{1}{(1 - r\alpha(t))}$$

$$Gcomp = G0 * \frac{1}{(1 - g\alpha(t))} \quad \cdots (8)$$

$$Bcomp = B0 * \frac{1}{(1 - b\alpha(t))}$$

Here, the brightness reduction rate is affected by the temperature differences when Tr ≥ rβ, Tg ≥ gβ, and Tb ≥ bβ, or the effect of the temperature differences on the brightness reduction rate can be ignored when Tr < rβ, Tg < gβ, and Tb < bβ.

Accordingly, in step S5 of FIG. 11, the compensation factor is corrected as in expression (8) by applying the temperature compensation factors rα (t), gα (t), and bα (t) only when Tr ≥ rβ, Tg ≥ gβ, and Tb ≥ bβ, or when Tr < rβ, Tg < gβ, and Tb < bβ, correction of the compensation factor by the temperature differences is not performed by setting rα (t) = 0, gα (t) = 0, and bα (t) = 0, respectively. Thus, correction of the compensation factor in step S5 of FIG. 11 is performed by multiplication or no multiplication by the factors 1/(1 - rα (t)), 1/(1 - gα (t)), and 1/(1 - bα (t)).

The subsequent step S6 of FIG. 11 is similar to step S6 of FIG. 7, so that the brightness of the light-emitting diode in the LED 1 can be compensated by changing the duty ratio of the pulse width as in the first embodiment.

The light-emitting diode display device 100 according to the second embodiment can also obtain the effect that the variation in brightness caused by aging of the brightness characteristics of the individual light-emitting diode elements can be compensated without the brightness measurement unit 9 blocking an image displayed on the LED display 10. Moreover, the brightness compensation method illustrated in FIG. 10 can maintain uniformity of the brightness by setting the initial value of the brightness low to keep the brightness constant.

Third Embodiment.

FIG. 12 is a graph for explaining the relationship between the lighting time and the brightness reduction rate of the LED aging display 21 at a plurality of duty ratios according to a third embodiment of the present invention. FIG. 12 illustrates an example of the green light-emitting diode, where solid lines indicate the relationship between the lighting time and the brightness reduction rate at corresponding duty ratios, and dotted lines sandwiching each solid line indicate individual variations of the light-emitting diodes.

As illustrated in FIG. 12, even with the normalized lighting time t on the horizontal axis, the light-emitting diodes making up the LED 1 have different actual brightness reduction rates depending on the duty ratio that determines the brightness at the time of use.

In the first and second embodiments, the light-emitting diode of each color on the LED aging display 21 is driven at the same duty ratio as the maximum duty ratio of the light-emitting diode of each color included in the LED display 10. In the third embodiment, however, the drive data generation unit 7 generates drive data that drives the measurement light-emitting diode of each color in the plurality of LEDs 1' on the LED aging display 21 at a plurality of different duty ratios including the maximum duty ratio. Accordingly, an average of the brightness may be taken for each color of the measurement light-emitting diode included in the LED aging display 21 to be able to obtain the relationship between the lighting time t and the brightness reduction rate of the LED aging unit 20 at the plurality of different duty ratios as indicated by the solid lines in FIG. 12.

As a result, the compensation factor in expressions (2) and (6) can be found by using accurate data of the brightness reduction rate obtained with the duty ratio closer to the actual driving condition of the LED display 10, whereby the accuracy of compensating the brightness can be further improved.

In the description of the first to third embodiments, the brightness compensation circuit 4 performs the brightness compensation of the light-emitting diodes included in the LED display 10 on the image signal output from the image signal processing circuit 3. However, as long as the duty ratio of the driving signal or the drive current for the light-emitting diodes included in the LED display 10 can be compensated in the end, the target of the brightness compensation is not limited to the image signal output from the image signal processing circuit 3.

Although the LED 1' used in the LED aging display 21 has the same light-emitting diode as that of the LED 1 on the LED display 10 in the aforementioned description, the variation in brightness and wavelength of the light-emitting diodes changes depending on the production lot. Moreover, the light-emitting diodes are classified using classification codes such as BIN codes depending on performance characteristics such as brightness and wavelength. In order to improve the accuracy of the brightness reduction rate, the LED 1 used in the LED display 10 and the LED 1' used in the LED aging display 21 may be made to have the same the production lot and the BIN code to be able to improve the accuracy of the brightness reduction rate measured and the brightness compensation.

In the description of the first and second embodiments, the presence or absence of the effect of the temperature differences Tr, Tg, and Tb on the brightness reduction rate is determined by using corresponding one of the thresholds $r\beta$, $g\beta$, and $b\beta$ for each color, the temperature differences being the differences between the temperatures tr, tg, and tb of the light-emitting diodes of the corresponding colors in the LED display 10 and the temperatures tre, tge, and tbe of the light-emitting diodes of the corresponding colors in the LED aging display 21. However, the accuracy of the brightness reduction rate and the brightness compensation can be further improved by setting a plurality of thresholds for each of the temperature differences Tr, Tg, and Tb and accordingly increasing the functions of the temperature compensation factor.

Specifically, thresholds $r\beta1$, $g\beta1$, and $b\beta1$ and thresholds $r\beta2$ ($> r\beta1$), $g\beta2$ ($> g\beta1$), and $b\beta2$ ($> b\beta1$) are set for the temperature differences Tr, Tg, and Tb of the red (R), green (G), and blue (B) colors, respectively, whereby the regions of temperature compensation for each color can be subdivided into the following three regions.

(Region 1) when $Tr < r\beta1$, $Tg < g\beta1$, and $Tb < b\beta1$
(Region 2) when $r\beta1 \leq Tr < r\beta2$, $g\beta1 \leq Tg < g\beta2$, and $b\beta1 \leq Tb < b\beta2$
(Region 3) when $Tr \geq r\beta2$, $Tg \geq g\beta2$, and $Tb \geq b\beta2$

Then, $r\alpha1$ (t), $g\alpha1$ (t), and $b\alpha1$ (t) as well as $r\alpha2$ (t), $g\alpha2$ (t), and $b\alpha2$ (t) are set as temperature compensation factors corresponding to the red (R), green (G), and blue (B) colors, respectively. It is thus assumed that the effect of the temperature differences on the brightness reduction rate can be ignored in (region 1), and that the brightness reduction rate is affected by the temperature differences in (region 2) and (region 3). Then in (region 2), the compensation factor may be corrected as in expression (5) or (8) by using the temperature compensation factors $r\alpha1$ (t), $g\alpha1$ (t), and $b\alpha1$ (t) while in (region 3), the compensation factor may be corrected as in expression (5) or (8) by using the temperature compensation factors $r\alpha2$ (t), $g\alpha2$ (t), and $b\alpha2$ (t).

In the aforementioned description, compensation of the brightness reduction rate is corrected by the temperature differences between the temperatures tr, tg, and tb measured for the light-emitting diodes included in all the LEDs 1 on the LED display 10 and the temperatures tre, tge, and tbe. However, depending on the temperature gradient of the LEDs 1 making up the LED display 10, the plurality of LEDs 1 may be regarded as one block to simplify the method of correcting compensation of the brightness reduction rate dependent on the temperature differences.

The configuration illustrated in the aforementioned embodiments merely illustrates an example of the content of the preset invention, and can thus be combined with another known technique or partially omitted and/or modified without departing from the scope of the present invention.

Reference Signs List

1, 1' LED; 2 input terminal; 3 image signal processing circuit; 4 brightness compensation circuit; 5 first drive unit; 6 lighting time storage unit; 7 drive data generation unit; 8 controller; 9 brightness measurement unit; 10 LED display; 11 brightness reduction rate storage unit; 12 compensation factor calculation unit; 13 LED display unit; 14 first temperature storage unit; 15 second temperature storage unit; 16 first temperature detection unit; 20 LED aging unit; 21 LED aging display; 22 second temperature detection unit; 50 second drive unit; 100 light-emitting diode display device; 130 signal line.

**Claims**

1. A light-emitting diode display device comprising:

   a display including a plurality of light-emitting diodes;
   a first drive unit to drive the light-emitting diodes on the basis of an image signal;
   a lighting time storage unit to store a cumulative lighting time that is an accumulated lighting time of the light-emitting diodes;
   a first temperature detection unit to detect a first temperature that is a temperature of each of the light-emitting diodes;
   a first temperature storage unit to store the first temperature;
   an aging display including a measurement light-emitting diode;
   a second drive unit to drive the measurement light-emitting diode on the basis of drive data;
   a drive data generation unit to generate the drive data;
   a second temperature detection unit to detect a temperature of the measurement light-emitting diode;
   a second temperature storage unit to store a second temperature that is a value based on the temperature detected by the second temperature detection unit;
   a brightness measurement unit to measure brightness of the measurement light-emitting diode;
   a brightness reduction rate storage unit to store the brightness measured by the brightness measurement unit as a brightness reduction rate in association with a lighting time of the measurement light-emitting diode;
   a compensation factor calculation unit to find a compensation factor for the light-emitting diodes on the basis of the cumulative lighting time and the brightness reduction rate, and correct the compensation factor on the basis of a difference between the first temperature and the second temperature; and
   a brightness compensation circuit to compensate the brightness of the light-emitting diodes in the image signal on the basis of the compensation factor.

2. The light-emitting diode display device according to claim 1, wherein
   the compensation factor calculation unit finds the compensation factor such that the brightness reduction rate of each of all the light-emitting diodes equals the maximum brightness reduction rate that is the largest among the brightness reduction rates corresponding to the cumulative lighting time.

3. The light-emitting diode display device according to claim 1, wherein
   the compensation factor calculation unit finds the compensation factor such that all the light-emitting diodes maintain initial brightness values.

4. The light-emitting diode display device according to claim 1, 2, or 3, wherein
   the drive data generation unit generates the drive data in which a duty ratio at which the measurement light-emitting diode is driven is set to the maximum duty ratio among duty ratios at which the first drive unit drives the light-emitting diodes.

5. The light-emitting diode display device according to claim 4, wherein
   the drive data generation unit generates the drive data that is used for driving at a plurality of different duty ratios, and the brightness reduction rate storage unit stores the brightness reduction rate at the plurality of different duty ratios.

# FIG.1

LIGHT-EMITTING DIODE DISPLAY DEVICE — 100

LED DISPLAY UNIT

13 13 13 13
13 13 13 13

CONTROLLER — 8

FIRST TEM-PERATURE STORAGE UNIT — 14

BRIGHTNESS COMPENSA-TION CIRCUIT — 4

IMAGE SIGNAL PROCESSING CIRCUIT — 3

COMPENSA-TION FACTOR CALCULATION UNIT — 12

LIGHTING TIME STORAGE UNIT — 6

LED AGING UNIT — 20

2

# FIG.2

# FIG.3

# FIG.4

# FIG.5

# FIG.6

# FIG.7

START

S1 — HAS UNIT TIME FOR BRIGHTNESS COMPENSATION ELAPSED? — NO

YES

S2 — SEARCH FOR MAXIMUM CUMULATIVE LIGHTING TIME

S3 — FIND MAXIMUM BRIGHTNESS REDUCTION RATE

S4 — FIND COMPENSATION FACTOR

S5 — CORRECT COMPENSATION FACTOR

S6 — COMPENSATE BRIGHTNESS

# FIG.8

ONE FRAME

(a)

(b) PW1: DUTY RATIO=85%

(c) PW2: DUTY RATIO=80%

# FIG.9

# FIG.10

# FIG.11

```
        ┌─────────────┐
        │    START    │
        └─────────────┘
               │
               ▼
          ╱─────────╲        S1
         ╱  HAS UNIT ╲
        ╱ TIME FOR    ╲   NO
       ╱ BRIGHTNESS    ╲──────────▶
       ╲ COMPENSATION  ╱
        ╲ ELAPSED?    ╱
         ╲──────────╱
               │ YES
               ▼             S4
        ┌──────────────────────┐
        │ FIND COMPENSATION     │
        │       FACTOR          │
        └──────────────────────┘
               │              S5
               ▼
        ┌──────────────────────┐
        │ CORRECT COMPENSATION  │
        │       FACTOR          │
        └──────────────────────┘
               │              S6
               ▼
        ┌──────────────────────┐
        │ COMPENSATE BRIGHTNESS │
        └──────────────────────┘
               │
               └──────────────────▶
```

# FIG.12

**INTERNATIONAL SEARCH REPORT**

| International application No. |
| --- |
| PCT/JP2016/075685 |

A.   CLASSIFICATION OF SUBJECT MATTER
*G09G3/32*(2016.01)i, *G09G3/20*(2006.01)i, *H01L33/00*(2010.01)i, *H05B37/02*
(2006.01)i

According to International Patent Classification (IPC) or to both national classification and IPC

B.   FIELDS SEARCHED

Minimum documentation searched (classification system followed by classification symbols)
G09G3/32, G09G3/20, H01L33/00, H05B37/02

Documentation searched other than minimum documentation to the extent that such documents are included in the fields searched
Jitsuyo Shinan Koho          1922-1996   Jitsuyo Shinan Toroku Koho   1996-2016
Kokai Jitsuyo Shinan Koho    1971-2016   Toroku Jitsuyo Shinan Koho   1994-2016

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| A | JP 2014-102484 A  (Lighthouse Technologies Ltd.),<br>05 June 2014 (05.06.2014),<br>paragraphs [0015] to [0017], [0021] to [0023]; fig. 1 to 3<br>& US 2014/0139115 A1<br>paragraphs [0017] to [0019], [0023] to [0025]; fig. 1 to 3<br>& CN 103839512 A          & KR 10-2015-0076201 A | 1-5 |

| ☒  Further documents are listed in the continuation of Box C. | ☐  See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    17 November 2016 (17.11.16) | Date of mailing of the international search report<br>    29 November 2016 (29.11.16) |
| --- | --- |
| Name and mailing address of the ISA/<br>    Japan Patent Office<br>    3-4-3,Kasumigaseki,Chiyoda-ku,<br>    Tokyo 100-8915,Japan | Authorized officer<br><br>Telephone No. |

Form PCT/ISA/210 (second sheet) (January 2015)

**INTERNATIONAL SEARCH REPORT**

International application No.

PCT/JP2016/075685

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2011-209480 A  (Sony Corp.), 20 October 2011 (20.10.2011), paragraphs [0014] to [0015], [0125] to [0133]; fig. 1, 12 & US 2011/0242143 A1 paragraphs [0058] to [0059], [0167] to [0175]; fig. 1, 12 & CN 102208161 A | 1 |
| A | JP 2013-250475 A  (Sony Corp.), 12 December 2013 (12.12.2013), entire text; all drawings & US 2013/0321387 A1 entire text; all drawings & CN 103456266 A | 1 |
| A | JP 2008-122516 A  (Matsushita Electric Industrial Co., Ltd.), 29 May 2008 (29.05.2008), paragraphs [0026] to [0039], [0055] to [0077]; fig. 1 to 3, 10 to 12 (Family: none) | 1-5 |
| A | JP 2008-65311 A  (Barco N.V.), 21 March 2008 (21.03.2008), entire text; all drawings & US 2008/0018570 A1 entire text; all drawings & CN 101105913 A | 1-5 |
| A | JP 2003-202838 A  (Matsushita Electric Industrial Co., Ltd.), 18 July 2003 (18.07.2003), paragraphs [0028] to [0034], [0044]; fig. 1 to 7, 14 (Family: none) | 1-5 |

Form PCT/ISA/210 (continuation of second sheet) (January 2015)

**EP 3 361 471 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H1115437 B

- JP 2006330158 A